## Europäisches Patentamt

## European Patent Office

## Office européen des brevets

(11) Veröffentlichungsnummer: **0 307 850 B1**

## (12) EUROPÄISCHE PATENTSCHRIFT

(45) Veröffentlichungstag der Patentschrift: **15.12.93**

(21) Anmeldenummer: **88114928.0**

(22) Anmeldetag: **13.09.88**

(51) Int. Cl.⁵: **H01L 27/06**, H01L 29/72, H01L 29/76

(54) Si/SiGe-Halbleiterkörper.

(30) Priorität: 16.09.87 DE 3731001
05.09.88 DE 3830102

(43) Veröffentlichungstag der Anmeldung:
22.03.89 Patentblatt 89/12

(45) Bekanntmachung des Hinweises auf die
Patenterteilung:
15.12.93 Patentblatt 93/50

(84) Benannte Vertragsstaaten:
DE GB

(56) Entgegenhaltungen:
EP-A- 0 144 242
EP-A- 0 228 516
DE-A- 2 719 464
DE-A- 3 620 686

IEEE TRANSACTIONS ON ELECTRON DEVICES, Band ED-33, Nr. 5, Mai 1986, Seiten 633-638, IEEE, New York, US; H. DAEMBKES et al.: "The n-channel SiGe/Si modulation-doped field-effect transistor"

PROCEEDINGS ELECTROCHEMICAL SOCIETY, 1st INTERNATIONAL SYMPOSIUM ON SILICON MBE, Toronto, Canada, 1985, 85-7, Seiten 400-405; T.P. PEARSALL et al.: "GexSi1-x modulation-doped p-channel field-effect transistors"

(73) Patentinhaber: **Licentia Patent-Verwaltungs-GmbH**
**Theodor-Stern-Kai 1**
**D-60596 Frankfurt(DE)**

(72) Erfinder: **Dämbkes, Heinrich**
**Stäudlenweg 29**
**D-7900 Ulm(DE)**

(74) Vertreter: **Schulze, Harald Rudolf, Dipl.-Ing. et al**
**Licentia Patent-Verwaltungs-GmbH**
**Theodor-Stern-Kai 1**
**D-60596 Frankfurt (DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die Erfindung betrifft einen Halbleiterkörper nach dem Oberbegriff des Patentanspruchs 1.

Halbleiterkörper der oben genannten Art finden in digitalen Schaltungen, in analogen Hochfrequenzschaltungen und in der Leistungselektronik Anwendung.

Aus der Veröffentlichung von H. Kroemer "Heterostructure Bipolar Transistors and Integrated Circuits", Proc. IEEE, Vol. 70(1), S. 13 (1982), ist der Aufbau von Heterobipolartransistoren (HBT) aus III/V-Halbleiterverbindungen bekannt, die z.B. für schnelle Mikrowellenschaltungen geeignet sind.

Weiterhin ist in der nicht vorveröffentlichen Patentanmeldung P 36 20 686.5 eine Anordnung aus einem HBT und einem modulationsdotierten Feldeffekttransistor (MODFET) aus III/V-Halbleiterverbindungen angegeben, die in schnellen elektronischen und optoelektronischen Hochfrequenzschaltungen verwendbar sind. Durch eine derartige Kombination von MODFET und HBT werden die Stromtreibereigenschaften unter Beibehaltung günstiger Eingangseigenschaften des MODFET erhöht.

Aus EP-A-0 144 242 ist eine npn - GaAs/AlGaAs - Schichtenfolge für eine gemeinsame Integration eines HBT und HFET bekannt.

Derartige III/V-Halbleiterbauelemente erfordern eine technisch aufwendige und kostenintensive Herstellungsweise.

In der DE-OS 27 19 464 ist ein Verfahren zur Herstellung von Si/SiGe-HBT angegeben, bei dem die Basisschicht aus SiGe und die Emitter- und Kollektorschicht aus Si aufgebaut sind.

Aus der DE-OS 35 42 482 und einer Veröffentlichung von T.P. Pearsall et al in der Proc. 1st. Intern.Symp. on Silicon MBE, Vol. 85-7, 400-405 (1985) sind ein MODFET aus einer Si/SiGe-Schichtenfolge bekannt.

Der Erfindung liegt daher die Aufgabe zugrunde, einen gattungsgemäßen Halbleiterkörper anzugeben, der für hohe Grenzfrequenzen (> 10 GHz) und für schnelle integrierte Schaltungen geeignet ist und insbesondere bei einer industriellen Massenfertigung zuverlässig und kostengünstig herstellbar ist.

Diese Aufgabe wird durch die im kennzeichnenden Teil des Patentanspruchs 1 angegebenen Merkmale gelöst. Vorteilhafte Ausgestaltungen und/oder Weiterbildungen sind den Unteransprüchen zu entnehmen.

Die Erfindung beruht darauf, daß der Aufbau der Halbleiterschichtenfolge derart gewählt ist, daß der HBT und MODFET aus der gleichen Schichtenfolge mit kostengünstiger Si-Technologie herstellbar sind.

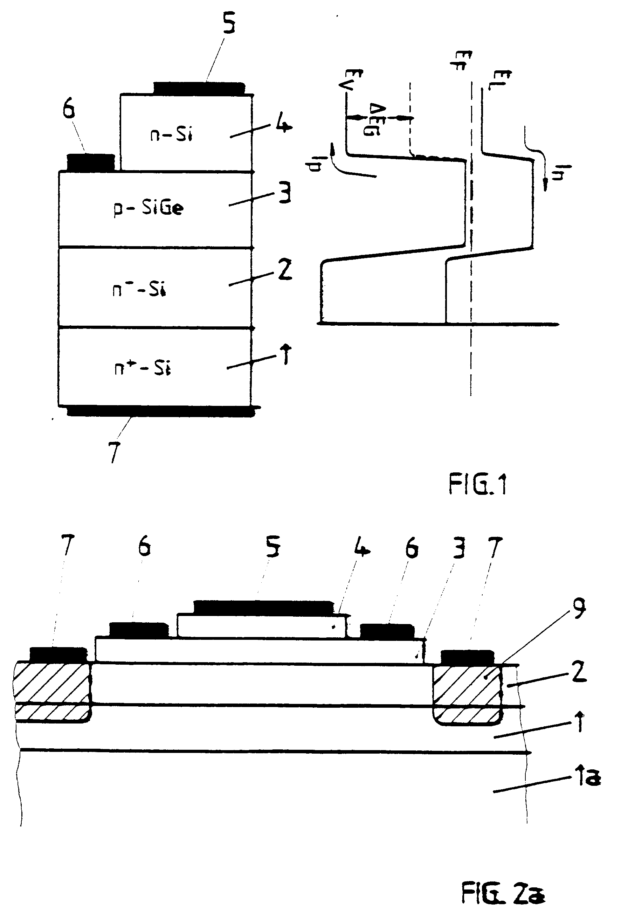

Um eine maximale Stromverstärkung des HBT zu erreichen, ist es vorteilhaft, daß die Basisschicht des Heterobipolartransistors (HBT) aus einem Halbleitermaterial besteht, das einen kleineren Bandabstand besitzt als die Emitterschicht. In Fig. 1 ist der prinzipielle Aufbau und das Energiebandschema eines HBT dargestellt, dessen Emitter-und Kollektorschicht 4, 2 aus n-dotiertem Si bestehen und die Basisschicht 3 aus p-dotiertem oder undotiertem SiGe, das einen kleineren Bandabstand besitzt als Si. Um den Löcherstrom $I_p$ so klein wie möglich zu gestalten, sollte auch nach Abbau der Potentialbarriere für den Elektronenstrom $I_n$ (z. B. durch Anlegen einer positiven Spannung $V_{BE}$ zwischen Basis und Emitter) für die Löcher noch eine deutliche Potentialbarriere existieren. Dies wird vorteilhafterweise dadurch erreicht, daß für die Basisschicht ein Halbleitermaterial mit geringerem Bandabstand $E_G$ verwendet wird als für die Emitterschicht. Der Bandabstand $E_G$ ist gegeben durch die Energiedifferenz zwischen Leitungsband $E_L$ und Valenzband $E_V$. Da die Basisschicht einen Bandabstand $E_G^B$ besitzt, der kleiner ist als der Bandabstand $E_G^E$ der Emitterschicht, ergibt sich eine Bandabstandsdifferenz:

$$\Delta E_G = E_G^E - E_G^B$$

Die Bandabstandsdifferenz $\Delta E_G$ kann im Prinzip sowohl im Leitungsband als $\Delta E_V$ als auch im Valenzband als $\Delta E_L$ auftreten.

Für eine maximale Stromverstärkung des HBT ist es jedoch von Vorteil, wenn die Bandabstandsdifferenz $\Delta E_G$ möglichst nur im Valenzband als $\Delta E_V$ auftritt: $\Delta E_G \approx \Delta E_V$
Diese Forderung ist im Si/SiGe-System erfüllt.

Durch die Erzeugung einer zusätzlichen Energiedifferenz zwischen Emitter- und Basisschicht, die sich als Potentialbarriere für Löcher auswirkt, wird die Löcherinjektion in den Emitterbereich stark reduziert. Dadurch wird der Emitterwirkungsgrad in vorteilhafterweise verbessert.

In FIG. 1 ist ein Si/SiGe-Schichtaufbau gezeigt, der sehr vorteilhaft für die Herstellung von HBT's auf Silizium-Basis ist. Derartige HBT's besitzen eine hohe Grenzfrequenz (> 20 GHz) und sind für schnelle Schaltungen mit Schaltzeiten deutlich unter 100 ps geeignet.

Durch Wahl des Ge-Anteils x in der $Si_{1-x}Ge_x$-Basisschicht ist die Bandabstandsdifferenz $\Delta E_G$ und somit $\Delta E_V$ in gewünschter Weise einstellbar. Aufgrund der unterschiedlichen Gitterkonstanten von Si und Ge treten unterhalb einer sogenannten kritischen Schichtdicke in der SiGe-Basisschicht elastische Verzerrungen auf, die zu einer Verringerung des Bandabstandes $E_G^B$ von SiGe führen und dadurch die Bandabstandsdifferenz $\Delta E_G$ zwischen

SiGe-Basis- und Si-Emitterschicht größer wird. Deshalb ist es vorteilhaft, die Schichtdicke der SiGe-Basisschicht so dünn zu wählen, daß für einen bestimmten Ge-Anteil x die kritische Schichtdicke nicht überschritten wird.

Die Erfindung wird im folgenden anhand von Ausführungsbeispielen unter Bezugnahme auf schematische Zeichnungen näher erläutert.

FIG. 1
zeigt den prinzipiellen Aufbau eines Si/SiGe-HBT und das entsprechende Energiebandschema.
FIG. 2a und 2b
zeigen den Si/SiGe-HBT in Mesabauweise und in planarer Bauform.
FIG. 3
zeigt eine planare Anordnung von HBT und MODFET aus einer Si/SiGe-Schichtenfolge.

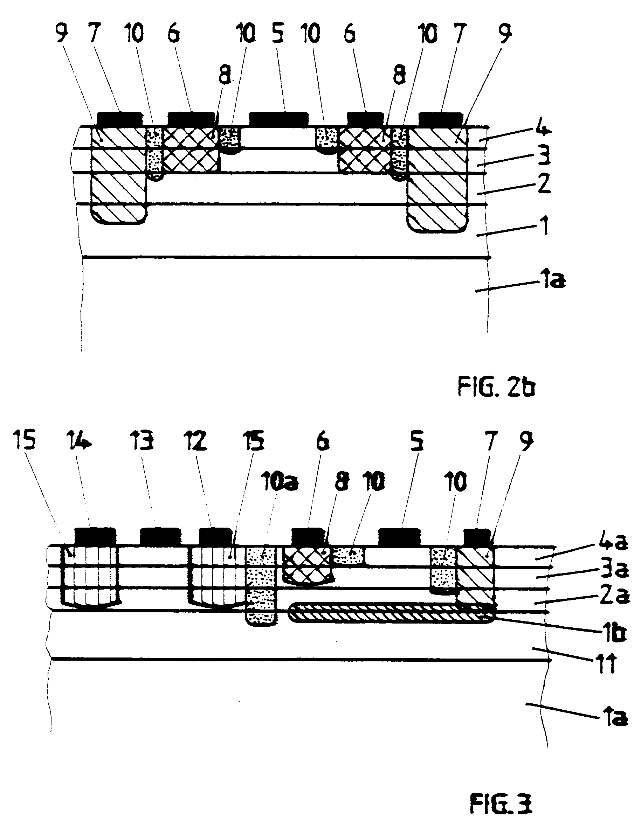

In den FIG. 1, 2a und 2b sind verschiedene Ausführungsformen eines HBT dargestellt. In allen drei Ausführungsformen besteht der HBT aus einer Halbleiterschichtenfolge aus

- einer n-dotierten Si-Schicht 4 mit einer Ladungsträgerkonzentration von $10^{17}$ bis $10^{20}$ cm$^{-3}$ und einer Schichtdicke von 0,1 $\mu$m bis 1 $\mu$m, die als Emitterbereich ausgebildet ist,
- einer p-dotierten Si$_{1-x}$Ge$_x$-Schicht 3 als Basisbereich mit einer Ladungsträgerkonzentration von 5 • $10^{16}$ bis $10^{20}$ cm$^{-3}$, die bei einem Ge-Anteil x = 0,2 eine unterkritische Schichtdicke von 50 nm bis 80 nm und bei einem Ge-Anteil x = 0,5 eine unterkritische Schichtdicke von etwa 10 nm besitzt,
- einer n$^-$-dotierten Si-Schicht 2 als Kollektorbereich mit einer Ladungsträgerkonzentration von 5 • $10^{15}$ bis $10^{17}$ cm$^{-3}$ und einer Schichtdicke von 0,2 $\mu$m bis 2 $\mu$m und
- einer n$^+$-dotierten Si-Schicht 1 als Kontaktschicht für den Kollektorbereich mit einer Ladungsträgerkonzentration von $10^{19}$ bis $10^{20}$ cm$^{-3}$ und einer Schichtdicke von z. B. 2 $\mu$m.

Im Ausführungsbeispiel 1 gemäß FIG. 1 sind der Emitterkontakt 5 auf die n-dotierte Si-Schicht 4, der Basiskontakt 6 auf die p-dotierte SiGe-Schicht 3 und der Kollektorkontakt auf die n$^+$-dotierte Si-Schicht 1 aufgebracht.

FIG. 2a zeigt als zweites Ausführungsbeispiel einen HBT in Mesabauweise, wobei die oben beschriebene Halbleiterschichtenfolge auf ein p$^-$-dotiertes oder hochohmiges Si-Substrat 1a aufgewachsen ist. Emitter-, Basis- und Kollektorkontakt 5, 6, 7, sind beispielsweise ringförmig auf die entsprechenden Halbleiterschichten aufgebracht.

FIG. 2b zeigt eine dritte planare Ausführungsform eines HBT, bei dem wiederum auf einem p$^-$-dotierten oder hochohmigen Substrat 1a die Halbleiterschichten 1, 2, 3, 4 aufgewachsen sind. Die z. B. ringförmigen elektrischen Kontakte 5, 6, 7 sind in einer Ebene auf der Oberfläche des HBT angebracht. Der Emitterkontakt 5 ist auf die n-dotierte Si-Schicht 4 aufgebracht. Der Basiskontakt 6 kontaktiert über ein p$^-$-dotiertes Gebiet 8 die p-dotierte SiGe-Schicht 3. Der Kollektorkontakt 7 ist über ein n$^+$-dotiertes Gebiet 9 mit der n$^+$-dotierten Si-Schicht 1 verbunden. Die n$^+$- bzw. p$^+$-dotierten Gebiete 8, 9 werden durch Ionenimplantation oder Diffusion mit einer Ladungsträgerkonzentration von mehr als $10^{18}$ cm$^{-3}$ erzeugt. Die unterschiedlich dotierten Gebiete 8, 9 des HBT und der Basis- und Emitterbereich sind durch isolierte Gebiete 10 aus z. B. polykristallinem Si oder Oxyd getrennt.

Der Emitterbereich des HBT kann anstatt aus einer gleichmäßig n-dotierten Si-Schicht 4 auch aus einer Si-Schicht aufgebaut sein, deren Dotierkonzentration in vertikaler Richtung zur p-dotierten SiGe-Schicht 3 hin von n$^+$-dotiertem Si nach n$^-$-dotiertem Si abnimmt. Dadurch wird die Basis-Emitter-Kapazität in vorteilhafterweise verringert, so daß höhere Frequenzen und kürzere Schaltzeiten für einen derartig aufgebauten HBT erreicht werden. Außerdem wird die Durchbruchspannung des HBT größer und damit die Betriebssicherheit des HBT höher.

Zur Erhöhung der Stromtreibereigenschaften in integrierten Schaltungen ist es beispielsweise vorteilhaft, einen MODFET mit einem HBT zu kombinieren.

In FIG. 3 ist ein viertes Ausführungsbeispiel für eine planare Anordnung eines Si/SiGe-MODFET und eines Si/SiGe-HBT dargestellt. Gemäß FIG. 3 ist auf einem hochohmigen oder p$^-$-dotierten Si-Substrat 1a eine undotierte SiGe-Pufferschicht 11 aufgewachsen. Diese Pufferschicht 11 bewirkt, daß Kristalldefekte (Gitterfehlanpassungen) im wesentlichen an der Grenzschicht Substrat - Pufferschicht lokalisiert sind und daß eine vorherbestimmbare mechanische Spannungsverteilung entsteht für die nachfolgend aufgebrachten Halbleiterschichten. Eine Einstellung dieser mechanischen Spannungsverteilung bei gegebenen Parametern der Schichten 2a bis 4a ist möglich durch Wahl der Zusammensetzung der SiGe-Legierung der Pufferschicht 11. Die Zusammensetzung und Dimensionierung der Pufferschicht 11 kann z. B. so gewählt werden, daß dadurch die kritische Schichtdicke der basisbildenden SiGe-Schicht 3a erhöht werden kann. Die Si$_{1-y}$Ge$_y$-Pufferschicht 11 besitzt beispielsweise eine Schichtdicke von 200 nm und einen Ge-Anteil y = 0,32. Mit dieser Pufferschicht 11 ist eine Halbleiterschichtenfolge aus

- einer n$^-$-dotierten Si-Schicht 2a mit einer Schichtdicke von 10 nm bis 1 $\mu$m und einer Ladungsträgerkonzentration von weniger als $10^{17}$ cm$^{-3}$,
- einer p-dotierten SiGe-Schicht 3a mit einer Ladungsträgerkonzentration von mehr als

$10^{16}$ cm$^{-3}$ und einer Schichtdicke von 20 nm und

- einer n-dotierten Si-Schicht 4a mit einer Ladungsträgerkonzentration von $5 \cdot 10^{15}$ bis $2 \cdot 10^{17}$ cm$^{-3}$ und einer Schichtdicke von 10 nm bis 1 μm

aufgewachsen.

Die Halbleiterschichtenfolge wird derart strukturiert, daß ein p-Kanal MODFET und ein npn-HBT auf dem gleichen Substrat ausbildbar sind. Dabei ist es vorteilhaft, die n-leitende Si-Schicht 4a lediglich in einem schmalen, räumlich begrenzten Bereich zu dotierten (sog. δ-Dotierung).

Drain- und Source-Anschluß 12, 14 des MODFET sind auf p$^+$-dotierten Gebieten 15, die senkrecht zu den Halbleiterschichten 2a, 3a, 4a verlaufen, aufgebracht. Der Gate-Anschluß 13 kontaktiert die n-dotierte Si-Schicht 4a. Der zweidimensionale Löchergas-Kanal bildet sich an der Heterogrenzfläche der Halbleiterschichten 2a, 3a aus. HBT und MODFET sind seitlich nebeneinander angeordnet und lediglich durch ein isoliertes Gebiet 10a getrennt. Der Emitteranschluß 5 des HBT ist auf die n-dotierte Si-Schicht 4a aufgebracht. Der Basisanschluß 6 kontaktiert über ein p$^+$-dotiertes Gebiet 8 die p-dotierte SiGe-Schicht 3a. Um den Kollektor niederohmig zu kontaktieren, ist im Bereich des HBT in die Halbleiterschichten 2a, 11 ein n$^+$-dotierter Kontaktbereich 1b diffundiert oder implantiert, der über ein n$^+$-dotiertes Gebiet 9 mit dem Kollektoranschluß verbunden ist.

Die Ladungsträgerkonzentrationen der n$^+$- bzw. p$^+$-dotierten Gebiete 1b, 8, 9, 15 betragen jeweils mehr als $10^{18}$ cm$^{-3}$. Diese hochdotierten Gebiete 1b, 8, 9, 15 werden entweder durch Ionenimplantation oder Diffusion erzeugt.

Emitter- und Basisbereich sowie Emitter- und Kollektorbereich sind durch isolierte Gebiete 10 getrennt, die z. B. aus Oxyd oder polykristallinem Si bestehen. Die Oberfläche des Halbleiterkörpers wird mit den in der Halbleitertechnik geläufigen Verfahren metallisiert und so strukturiert, daß die elektrischen Anschlüsse von MODFET und HBT in einer Ebene angebracht sind.

Eine weitere Ausführungsform ist die Kombination eines n-Kanal Si/SiGe-MODFET mit einem npn-Si/SiGe-HBT. Anstelle der p-dotierten SiGe-Schicht 3a enthält die Halbleiterschichtenfolge des Ausführungsbeispiels 4 eine n-dotierte SiGe-Schicht, die vorteilhafterweise δ-dotiert ist mit einer Dotierkonzentration von etwa $10^{12}$ Ladungsträgern pro cm$^2$. Im Bereich des HBT ist diese SiGe-Schicht p-dotiert, z. B. durch selektive Ionenimplantation.

Source- und Drain-Anschluß des MODFET sind auf n$^+$-dotierten Gebieten angebracht, die senkrecht zu den Halbleiterschichten 2a, 3a, 4a verlaufen (FIG. 3).

An der Heterogrenzfläche der Halbleiterschichten 2a, 3a entsteht ein zweidimensionales Elektronengas. Dabei werden die Elektronen im wesentlichen innerhalb der Si-Schicht 2a geführt.

Als Dotiermaterialien für die n-Dotierung der Halbleiterschichten und leitenden Gebiete des erfindungsgemäßen Halbleiterkörpers wird beispielsweise Sb und für die p-Dotierung Ga verwendet. Halbleiterkörper gemäß der Erfindung lassen sich beispielsweise mit Hilfe der Molekularstrahl-Epitaxie und/oder der chemischen Gasphasen-Epitaxie herstellen.

**Patentansprüche**

1. Halbleiterkörper, bestehend aus einem Si-Substrat, auf dem eine Si/SiGe-Schichtenfolge aufgebracht ist, dadurch gekennzeichnet,
   - daß die Si/SiGe-Schichtenfolge zumindest eine n-dotierte Si-Schicht (4, 4a), eine p-dotierte SiGe-Schicht (3, 3a) und eine n$^-$-dotierte Si-Schicht (2, 2a) enthält, in der sich mindestens ein Heterobipolartransistor und ein Heterostruktur-Feldeffekttransistor befinden, die nebeneinander angeordnet sind, und
   - daß die elektrischen Anschlüsse von Heterobipolartransistor und Heterostruktur-Feldeffekttransistor in einer Ebene angebracht sind , wobei die Kontaktierung der aktiven Bauelementschichten über dotierte Gebiete erfolgt.

2. Halbleiterkörper nach Anspruch 1, dadurch gekennzeichnet, daß die Schichtenfolge mindestens eine SiGe-Schicht enthält mit einer Schichtdicke die kleiner oder gleich der kritischen Schichtdicke ist, so daß mechanische Spannungsdefekte vermieden werden.

3. Halbleiterkörper nach einem der vorhergehenden Ansprüche, dadurch gekennzeichnet, daß die n-dotierte Si-Schicht (4) als Emitterschicht, die SiGe-Schicht (3) als Basisschicht und die n$^-$-dotierte Si-Schicht (2) als Kollektorschicht ausgebildet ist.

4. Halbleiterkörper nach einem der vorhergehenden Ansprüche 1 bis 3, dadurch gekennzeichnet, daß auf das Substrat (1a) eine SiGe-Pufferschicht (11) und darauf die Halbleiterschichten (2, 3, 4) aufgewachsen sind.

5. Halbleiterkörper nach einem der vorhergehenden Ansprüche 1 bis 4, dadurch gekennzeichnet, daß auf dem gleichen Substrat (1a) unter Zwischenfügen eines elektrisch isolierenden Gebietes (10a) mindestens ein Heterobipolartransistor und ein Feldeffekttransistor nebeneinander angeordnet sind.

6. Halbleiterkörper nach Anspruch 5, dadurch gekennzeichnet,
    - daß der Feldeffekttransistor als p-Kanal MODFET ausgebildet ist und
    - daß der p-leitende Kanal sich an der Heterogrenzfläche zwischen SiGe-Schicht (3a) und n⁻-dotierter Si-Schicht (4a) in der SiGe-Schicht (3a) ausbildet.

7. Halbleiterkörper nach Anspruch 5, dadurch gekennzeichnet,
    - daß der Feldeffekttransistor als n-Kanal MODFET ausgebildet ist,
    - daß die SiGe-Schicht (3a) im Bereich des Feldeffekttransistors eine räumlich begrenzte, negative $\delta$-Dotierung aufweist,
    - daß sich der n-leitende Kanal an der Heterogrenzfläche zwischen SiGe-Schicht (3a) und n⁻-dotierter Si-Schicht (2a) in der Si-Schicht (2a) ausbildet und
    - daß im Bereich des Heterobipolartransitors die SiGe-Schicht (3a) p-dotiert ist.

8. Halbleiterkörper nach Anspruch 5, dadurch gekennzeichnet, daß die Kontaktierung der n⁻-dotierten Si-Schicht (2a) des Kollektorbereiches über einen n⁺-dotierten Kontaktbereich (1b) erfolgt.

## Claims

1. Semiconductor body consisting of an Si substrate on which a Si/SiGe layer sequence is applied, characterised thereby that the Si/SiGe layer sequence comprises at least one n-doped Si layer (4, 4a), a p-doped SiGe layer (3, 3a) and an n⁻-doped Si layer (2, 2a), in which are disposed at least one heterobipolar transistor and a heterostructure field effect transistor which are arranged beside one another, and that the electrical connections of heterobipolar transistor and heterostructure field effect transistor are situated in one plane, wherein the contacting of the active component element layers is effected by way of doped zones.

2. Semiconductor body according to claim 1, characterised thereby that the layer sequence comprises at least one SiGe layer with a layer thickness which is smaller than or equal to the cricial layer thickness, so that mechanical voltage defects are avoided.

3. Semiconductor body according to one of the preceding claims, characterised thereby that the n-doped Si layer (4) is consutrcted as an emitter layer, the SiGe layer (3) as a base layer and the n⁻-doped Si layer (2) as a collector layer.

4. Semiconductor body according to one of the preceding claims 1 to 3, characterised thereby that an SiGe buffer layer (11) is grown on the substrate (1a) and the semiconductor layers (2, 3, 4) are grown on the buffer layer.

5. Semiconductor body according to one of the preceding claims 1 to 4, characterised thereby that at least one heterobipolar transistor and a field effect transistor are arranged beside one another on the same substrate (1a) with interposition of an electrically insulating region (10a).

6. Semiconductor body according to claim 5, characterised thereby that the field effect transistor is constructed as a p-channel MODFET and that the p-conducting channel is formed in the SiGe layer (3a) at the hetero boundary surface between SiGe layer (3a) and n⁻-doped Si layer (4a).

7. Semiconductor body according to claim 5, characterised thereby that the field effect transistor is constructed as an n-channel MODFET, that the SiGe layer (3a) has a spatially limited, negative $\delta$-doping in the region of the field effect transistor, that the n-conducting channel is formed in the Si layer (2a) at the hetero boundary surface between SiGe layer (3a) and n⁻-doped Si layer (2a) and that the SiGe layer (3a) is p-doped in the region of the heterobipolar transistor.

8. Semiconductor body according to claim 5, characterised thereby that the contacting of the n⁻-doped Si layer (2a) of the collector region is effected by way of a n⁺-doped contact region (1b).

## Revendications

1. Corps semi-conducteur consistant en un substrat de Si sur lequel est appliquée une succession de couches de Si/SiGe, caractérisé
    - en ce que la succession de couches de Si/SiGe contient au moins une couche de Si dopée N (4, 4a), une couche de SiGe dopée P (3, 3a) et une couche de Si dopée N⁻ (2, 2a) dans laquelle se trouvent au moins un transistor hétérobipolaire et un transistor à effet de champ à hétérostructure qui sont disposés l'un à côté de l'autre, et

- en ce que les connexions électriques du transistor hétérobipolaire et du transistor à effet de champ à hétérostructure sont appliquées dans un plan, la réalisation des liaisons des couches actives d'éléments constitutifs étant accomplie par l'intermédiaire de domaines dopés.

2. Corps semi-conducteur selon la revendication 1, caractérisé en ce que la succession de couches contient au moins une couche de SiGe dont l'épaisseur est inférieure ou égale à l'épaisseur critique de sorte que les défauts mécaniques de tension sont évités.

3. Corps semi-conducteur selon l'une des revendications précédentes, caractérisé en ce que la couche de Si dopée N (4) est sous forme d'une couche d'émetteur, la couche de SiGe (3) est sous forme d'une couche de base et la couche de Si dopée $N^-$ (2) est sous forme d'une couche de collecteur.

4. Corps semi-conducteur selon l'une des revendications précédentes 1 à 3, caractérisé en ce que, sur le substrat (1a), sont formées une couche tampon de SiGe (11) et sur celle-ci les couches semi-conductrices (2,3,4).

5. Corps semi-conducteur selon l'une des revendications précédentes 1 à 4, caractérisé en ce qu'au moins un transistor hétérobipolaire et un transistor à effet de champ sont disposés côte à côte sur le même substrat (1a) avec interposition d'un domaine électriquement isolant (10a).

6. Corps semi-conducteur selon la revendication 5, caractérisé

- en ce que le transistor à effet de champ est sous forme d'un transistor MODFET à canal P et
- en ce que le canal à conduction P se forme dans la couche de Si-Ge (3a) au niveau de la surface d'hétérojonction entre la couche de SiGe (3a) et la couche de Si dopée $N^-$ (4a).

7. Corps semi-conducteur selon la revendication 5, caractérisé

- en ce que le transistor à effet de champ est sous forme d'un transistor MODFET à canal N,
- en ce que la couche de SiGe (3a) présente dans le domaine du transistor à effet de champ un dopage $\delta$ négatif spatialement limité

- en ce que le canal à conduction N se forme dans la couche de Si (2a) au niveau de la surface d'hétérojonction entre la couche de SiGe (3a) et la couche de Si dopée $N^-$ (2a) et
- en ce que la couche de SiGe (3a) est dopée P dans le domaine du transistor hétérobipolaire.

8. Corps semi-conducteur selon la revendication 5, caractérisé en ce que la réalisation des liaisons de la couche de Si dopée $N^-$ (2a) du domaine du collecteur est accomplie par l'intermédiaire d'un domaine de contact dopé $N^+$ (1b).

FIG.1

FIG. 2a

9  7  10  6      10  5  10  6      10  7  9

8                        8

4
3
2

1

1a

FIG. 2b

15  14  13  12  15   6      5    7  9

10a   8  10   10

4a
3a
2a

1b
11

1a

FIG. 3